# EUROPEAN PATENT APPLICATION

(11) **EP 3 606 297 A1**
(43) Date of publication of application: **05.02.2020**
(21) Application number: 19187666.3
(22) Date of filing: 22.07.2019
(51) Int. Cl.: H05K 1/03, H05K 1/09, H05K 3/28, H05K 3/00, H05K 3/12

(54) **PRINTING PROCESS AND SYSTEM**

(30) Priority: 24.07.2018 US 201816043256
(71) Applicant: Xerox Corporation, Webster, NY 14580 (US)
(72) Inventor: GOREDEMA, Adela, Ancaster, Ontario L9G 0E1 (CA); SMITHSON, Chad, Toronto, Ontario M6H 3W3 (CA); ABRAHAM, Biby E., Mississauga, Ontario L5M 7E2 (CA); CHRETIEN, Michelle N., Mississauga, Ontario L5N 3V8 (CA); CHOPRA, Naveen, Oakville, Ontario L6H 5W4 (CA); HALFYARD, Kurt I., Mississauga, Ontario L5M 6K7 (CA)
(74) Representative: Lord, Michael

(57) **Abstract**

Disclosed herein is a printing method and system for forming a three dimensional article. The method includes depositing a UV curable composition and applying UV radiation to cure the UV curable composition to form a 3D structure. The method includes depositing a conductive metal ink composition on a surface of the 3D structure and annealing the conductive metal ink composition at a temperature of less than the glass transition temperature of the UV curable composition to form a conductive trace on the 3D structure. The method includes depositing a second curable composition over the conductive trace; and curing second curable composition to form the 3D printed article having the conductive trace embedded therein.

## Description

The present invention relates to a printing process. More particularly, the disclosure herein provides a method of an improved process for manufacturing conductive lines on electronic devices and 3-dimensional (3D) surfaces.

Printing functional articles is an extension of printed electronics, where interactive and multifunctional devices are printed rather than assembled. The ability to print shapes, forms, and structures as well as electronics and other functionalities will pave the way to novel, smart components for automotive and rail, aerospace, military, home appliances, and many other applications.

Conductive 3D printed articles have many applications in creating smart components for automotive and rail, aerospace, military, home appliances and many other applications. These smart components include functional elements such as conductive tracks and electronics in 3D printed articles. Such functional elements create high value products. Most 3D printed articles are manufactured from polymeric materials. In order to fabricate 3D printed structural electronics, highly conductive materials which are compatible with structural materials used in 3D printing are required. Conductive inks need to be annealed at very high temperatures which can lead to the melting/softening of the polymeric 3D printed structures. There is a need to identify conductive inks that are compatible with structural materials to enable fabrication of conductive 3D articles.

According to an embodiment, there is provided a printing method for forming a three dimensional (3D) printed article. The method includes depositing a UV curable composition and applying UV radiation to cure the UV curable composition to form a 3D structure. The method includes depositing a conductive metal ink composition on a surface of the 3D structure and annealing the conductive metal ink composition at a temperature less than the glass transition temperature of the UV curable composition to form a conductive trace on the 3D structure. The method includes depositing a second UV curable composition over the conductive trace; and curing second UV curable composition to form the 3D printed article having the conductive trace embedded therein.

According to an embodiment there is provided a printing system.
The printing system includes a first three dimensional (3D) printer for depositing a UV curable composition and a first UV curing apparatus for curing the UV curable composition to form a 3D structure. The printing system includes a printer for depositing a conductive metal ink composition on a surface of the 3D structure and a heater for drying and annealing the conductive metal ink composition at a temperature less than the glass transition temperature of the UV curable composition to form a conductive trace on the cured UV curable composition of the 3D structure. The printer system includes a second 3D printer for depositing a second UV curable composition over the conductive trace and a second UV curing apparatus for curing the second UV curable composition deposited over the conductive trace to form a 3D printed article having a conductive trace embedded therein.

According to another embodiment there is provided a printing method. The printing method includes depositing a conductive metal ink composition on a surface of a three dimensional (3D) structure having a glass transition temperature. The printing method includes annealing the conductive metal ink composition at a temperature of less than the glass transition temperature to form a conductive surface on the 3D structure. The printing method includes depositing a second UV curable composition over the conductive surface and curing the second UV curable composition to form 3D printed article having the conductive surface embedded therein.
FIG. 1 shows a schematic depiction of a printing system for various embodiments disclosed herein.
FIG. 2 shows a flow chart illustrating a method according to various embodiments disclosed herein.
FIG. 3 shows conductivity profiles for various embodiments disclosed herein.
FIG. 4 illustrates an antenna made from embodiments disclosed herein.

Notwithstanding that the numerical ranges and parameters setting forth the broad scope of embodiments are approximations, the numerical values set forth in the specific examples are reported as precisely as possible. Any numerical value, however, inherently contains certain errors necessarily resulting from the standard deviation found in their respective testing measurements. Moreover, all ranges disclosed herein are to be understood to encompass any and all sub-ranges subsumed therein. For example, a range of "less than 10" can include any and all sub-ranges between (and including) the minimum value of zero and the maximum value of 10, that is, any and all sub-ranges having a minimum value of equal to or greater than zero and a maximum value of equal to or less than 10, e.g., 1 to 5. In certain cases, the numerical values as stated for the parameter can take on negative values. In this case, the example value of range stated as "less than 10" can assume negative values, e.g. - 1, -2, -3, -10, -20, -30, etc.

Disclosed herein is a printing process and system for forming a three dimensional 3D printed article. The process includes depositing a UV curable composition and applying UV radiation to cure the UV curable composition to form the three dimensional structure. In embodiments, the UV curable composition is electrically insulating. In embodiments, the UV curable composition has a glass transition temperature of equal to or less than 130 °C. In embodiments, the UV curable composition has a glass transition temperature of equal to or less than 120 °C. In embodiments, the UV curable composition has a glass transition temperature of equal to or less than 110 °C or less than 100 °C. The process includes depositing a conductive metal ink composition on a surface of the three dimensional structure and curing the conductive metal ink composition at a temperature of less than the glass transition temperature of the cured UV curable composition to form a conductive trace on the three dimensional structure. The process includes depositing a UV curable composition over the conductive trace and applying UV radiation to cure the second UV curable composition to form three dimensional printed article having a conductive trace embedded therein.

In embodiments, the process may include depositing an UV curable composition on some areas of the conductive traces, curing the UV curable composition and depositing and curing other conductive metal ink layers and depositing and curing other UV curable compositions to build an electronic circuit. This process may be used to make printed electronics such as electronic circuitry, antennas, inductors and other electronic components. The process includes depositing a second UV curable composition over the electronic circuit and applying UV radiation to cure the second UV curable composition to form a three dimensional article having the electronic device embedded therein.

Multi-Jet Manufacturing (MJM) is an inkjet printing process that uses piezo printhead technology to deposit photocurable plastics layer by layer. UV curable materials include acrylates and methacrylates. Such materials typically have a storage modulus at 25 °C of from about 1000 MPa to about 2500 MPa when cured.

The MJM process is used to form the 3D printed structures of UV curable materials having a storage modulus at 25 °C of from about 1000 MPa to about 2500 MPa when cured. By providing partially embedded electronic circuits or conductive traces within the 3D printed structure of UV curable materials having a storage modulus at 25 °C of from about 1000 MPa to about 2500 MPa when cured, useful articles such as antennas, sensors, inductors, heaters, microsystems, printed circuit boards, light emitting diodes can be manufactured.

3D articles can be built by the incorporation of functional elements such as conductive traces and electronics into 3D printed structures. This enhances functionality and creates high value products. In order to fabricate 3D printed structural electronics, highly conductive materials which are compatible with structural materials used in 3D printing are required. Most available conductive inks need to be annealed at very high temperatures which can lead to the melting/softening of the polymeric 3D printed structures. There is a need to identify conductive inks that are compatible with structural materials to enable fabrication of conductive 3D articles.

Disclosed herein is a method and system for producing a conductive 3D printed article. The 3D article was fabricated by printing conductive traces or lines on a 3D printed article. Thermal annealing of the conductive metal ink to form conductive traces was achieved at temperatures of less than 120 °C, or in embodiments, the annealing temperature can be less than 110°C, or the annealing temperature can be less than 100 °C or in embodiments the annealing temperature can be 90 °C or less or the annealing temperature can be less than 80 °C, or less or the annealing temperature can be less than 70 °C or in embodiments the annealing temperature can be 60 °C or less. The annealing temperature of the conductive trace is less than the glass transition temperature of the 3D structure. In embodiments, the conductive metal ink can be annealed photonically. Photonic anealing is achieved using a thermal pulse. The thermal pulse is very fast (milliseconds) so that the 3D structure does not experience a significant temperature rise during the pulse. Annealing the 3D structure at such low temperatures does not affect the structural integrity of the 3D structure. Low resistances of the conductive traces were achieved. The ability to achieve these low resistances indicates that there is no negative interaction between the UV curable composition used to build the 3D printed article having conductive traces embedded therein.

The UV curable formulation herein may include at least one acrylate monomer. The acrylate monomer may be monofunctional or difunctional oligomers, multifunctional oligomers, and the like, and combinations thereof may be used. Suitable acrylate monomers and oligomers include methacrylate, acrylic acid, aromatic acrylates such as phenyl acrylates, phenol acrylates, benzyl acrylates, and the like; ester acrylates such as polyester acrylates, acrylic acid esters, urethane acrylates, and the like, and mixtures or combinations thereof.

In embodiments, at least one monofunctional acrylate is present in the 3D UV curable composition structural material. Examples of monofunctional acrylates include 2-phenoxyethylacrylate, alkoxylated lauryl acrylate, alkoxylated phenol acrylate, alkoxylated tetrahydrofurfuryl acrylate, caprolactone acrylate, cyclic trimethylolpropane formyl acrylate, ethylene glycol methyl ether methacrylate, ethoxylated nonyl phenol acrylate, isodecyl acrylate, isooctyl acrylate, lauryl acrylate, octadecyl acrylate (stearyl acrylate), tetrahydrofurfuryl acrylate (SR285, from Sartomer Chemical Co.), tridecyl acrylate, 4-acryolyl morpholine (from Aldrich Chemical Co.), tetrahydrofurfuryl methacrylate, 2-phenoxyethyl methacrylate, lauryl methacrylate, polypropylene glycol monomethacrylate, polyethylene glycol monomethacrylate, and tridecyl methacrylate allyl acrylate, allyl methacrylate, methyl (meth)acrylate, ethyl (meth)acrylate, n-propyl (meth)acrylate, n-butyl (meth)acrylate, isobutyl (meth)acrylate, n-hexyl (meth)acrylate, 2-ethylhexyl (meth)acrylate, n-octyl (meth)acrylate, n-decyl (meth)acrylate, n-dodecyl (meth)acrylate, 2-hydroxyethyl (meth)acrylate, 2- and 3-hydroxypropyl (meth)acrylate, 2-methoxyethyl(meth)acrylate, 2-ethoxyethyl (meth)acrylate, 2- or 3-ethoxypropyl (meth)acrylate, tetrahydrofurfuryl (meth)acrylate, 2-(2-ethoxyethoxy)ethyl acrylate, cyclohexyl methacrylate, glycidyl acrylate, and the like, and mixtures thereof. Specific examples of monoacrylate monomers include isobornyl acrylate (IBOA), commercially available from SARTOMER under the trade name SR 506 or SR 506A or SR423A (reactive diluent for oligomers); nonyl phenol acrylate such as 2-[(butyamino) carbonyl] oxy] ethyl acrylate (Photomer 4184 reactive, non-yellowing diluent) from IGM Resins or BASF; and the like, and mixtures or combinations thereof. In embodiments, the monofunctional acrylate can act as a reactive diluent for oligomers.

In optional embodiments, at least one difunctional acrylate is present in the 3D UV curable composition structural material. In some embodiments, difunctional acrylate, diacrylate and/or dimethacrylate include esters of aliphatic, cycloaliphatic or aromatic diols, including 1,3- or 1,4-butanediol, neopentyl glycol, 1,6-hexanediol, diethylene glycol, triethylene glycol, tetraethylene glycol, triethylene glycol dimethacrylate, cyclohexane dimethanol diacrylate, polyethylene glycol, tripropylene glycol, ethoxylated or propoxylated neopentyl glycol, 1,4-dihydroxymethylcyclohexane, 2,2-bis(4-hydroxycyclohexyl)propane or bis(4-hydroxycyclohexyl)methane, hydroquinone, 4,4'-dihydroxybiphenyl, bisphenol A, bisphenol F, bisphenol S, ethoxylated or propoxylated bisphenol A, ethoxylated or propoxylated bisphenol F or ethoxylated or propoxylated bisphenol S. Specific examples of difunctional acrylates include triethylene glycol diacrylate, commercially available from SARTOMER under the trade name SR 272 or SR 205 or TR272 (TriEGDA high boiling monomer) from Sartomer, Evonik or BASF, tetraethylene glycol diacrylate under the tradename SR268 (Tetra EGDA low volatility, difunctional acrylate) from Sartomer, Evonik or BASF; 1,12 dodecane diol diacrylate, 1,3-butylene glycol diacrylate, 1,4-butanediol diacrylate, 1,6-hexanediol diacrylate (SR238B, from Sartomer Chemical Co.), alkoxylated hexanediol diacrylate, alkoxylated neopentyl glycol diacrylate, cyclohexane dimethanol diacrylate, diethylene glycol diacrylate (SR230, from Sartomer Chemical Co.), ethoxylated (4) bisphenol A diacrylate (SR601, from Sartomer Chemical Co.), polyethylene glycol (400) diacrylate (SR344, from Sartomer Chemical Co.), propoxylated (2) neopentyl glycol diacrylate (SR9003B, from Sartomer Chemical Co.), tricyclodecane dimethanol diacrylate (SR833S, from Sartomer Chemical Co.), tripropylene glycol diacrylate or the like, and mixtures or combinations thereof.

In embodiments, a trifunctional acrylate or multifunctional oligomer may include 1,1-trimethylolpropane triacrylate, ethoxylated or propoxylated 1,1,1-trimethylolpropanetriacrylate, ethoxylated or propoxylated glycerol triacrylate, pentaerythritol monohydroxy triacrylate; ethoxylated trimethylolpropane triacrylate; polyester acrylates, urethane acrylates, polyester urethane acrylates such as Bomar BR 741 from Dymax, dipentaerythritol monohydroxy pentaacrylate or bis(trimethylolpropane) tetraacrylate, ethoxylated (9) trimethylol propane triacrylate, pentaerythritol triacrylate, propoxylated (3) glyceryl triacrylate (SR9020, from Sartomer Chemical Co.), propoxylated (3) trimethylol propane triacrylate (SR492, from Sartomer Chemical Co.), tris (2-hydroxylethyl) isocyanurate triacrylate (SR368, from Sartomer Chemical Co.), di-trimethylolpropane tetraacrylate, dipentaerythritol pentaacrylate (SR399, from Sartomer Chemical Co.), ethoxylated (4) pentaerythritol tetraacrylate (SR494, from Sartomer Chemical Co.), and the like, and combinations thereof. Urethane acrylates suitable for use in build materials described herein can be prepared in a known manner, typically by reacting a hydroxyl-terminated oligomeric urethane with acrylic acid or methacrylic acid to give the corresponding urethane acrylate or urethane methacrylate, or by reacting an isocyanate-terminated prepolymer with hydroxyalkyl acrylates or methacrylates to give the urethane acrylate or urethane methacrylate.

Oligomers may include polyester acrylates, polyether acrylates, epoxy acrylates, and urethane acrylates. Examples of polyester acrylate oligomers include: CN293, CN299, CN292, CN296, CN2279, CN2262, CN2267, CN2200, CN2203, CN2281, and CN2281 from Sartomer Chemical Co. Examples of polyether acrylate oligomers include: Genomer 3364, Genomer 3414, Genomer 3457, Genomer 3497, all available from Rahn Corp. Examples of epoxy acrylate oligomers include: CN104Z, CN2102E, CN110, CN120Z, CN116, CN117, CN118, CN119, and CN2003B, all available from Sartomer Chemical Co. Also, Genomer 2235, Genomer 2252, Genomer 2253, Genomer 2255, Genomer 2259, Genomer 2263, Genomer 2280, and Genomer 2281, all available from Rahn Corp. Examples of urethane acrylate oligomers include aromatic urethane oligomers such as: CN9782, CN9783, CN992, CN975 (hexafunctional), CN972, all available from Sartomer Chemical Co. Also Genomer 4622 and Genomer 4217 (Rahn Corp.). Aliphatic urethanes include: CN9004, CN9005, CN9006, CN9006, CN9023, CN9028, CN9178, CN969, CN9788, CN986, CN989, CN9893, CN996, CN2920, CN3211, CN9001, CN9009, CN9010, CN9011, CN9071, CN9070, CN929, CN962, CN9025, CN9026, CN968, CN965, CN964, CN991, CN980, CN981, CN983, CN9029, CN9030, CN9031, CN9032, CN9039, CN9018, CN9024, CN9013 (all from Sartomer Chemical Co.). Also: Genoer 4188, Cnomer 4215, Genomer 4230, Genomer 4267, Genomer 4269, Genomer 4312, Genomer 4316, Genomer 4425, Genoer 4590, Genomer 4690 (all from Rahn Corp.). Other examples of urethane acrylate oligomers include the Bomar™ series of urethane oligomers available from Dymax Corporation, such as: BR-441B, BR-471, BR704P, BR-741, BR-742P, BR-7432GI30, BR-744BT, BR742M, B-952, BR-116, BR-146, BR-202. Other examples from IGM Resins include Photomer 6008, Photomer 6010, Photomer 6019, Photomer 6019, Photomer 6184, Photomer 6630, and Photomer 6892 (trifunctional urethane acrylate oligomers).

In embodiments, the monofunctional acrylate monomers, difunctional oligomer, or tri or higher multifunctional oligomer may be present in the UV curable composition in any desired or effective amount. In specific embodiments, the monofunctional acrylic monomer may be present in an amount of from about 20 to about 60 percent, or from about 25 to about 50 percent, or from about 30 to about 40 percent by weight, based on the total weight of the UV curable composition.

In embodiments, the optional difunctional acrylate oligomer may be present in the UV curable composition in any desired or effective amount. In specific embodiments, the difunctional acrylate oligomer may be present in an amount of from about 1 to about 50 weight percent, or from about 5 to about 40 percent, or from about 10 to about 30 percent, by weight, based on the total weight of the UV curable composition.

In embodiments, the optional trifunctional acrylate oligomer may be present in the UV curable composition in any desired or effective amount. In specific embodiments, the trifunctional acrylate oligomer may be present in an amount of from about 1 to about 25 percent, or from about 5 to about 20 percent, or from about 5 to about 10 percent by weight, based on the total weight of the UV curable composition.

The UV curable composition may optionally include an initiator, such as, for example, a photoinitiator. Such an initiator is desirable for assisting in curing of the UV curable composition. In embodiments, a photoinitiator that absorbs radiation, for example ultra-violet (UV) light radiation of sufficient wavelength and intensity to initiate curing of the curable components of the UV curable composition may be used. In the printing of a three dimensional article, layers of deposited UV curable composition may be cured prior to the deposition of another or adjacent layer of UV curable composition.

Examples of suitable photoinitiators include benzophenones, benzoin ethers, benzyl ketals, α-hydroxyalkylphenones, α-alkoxyalkylphenones α-aminoalkylphenones and acylphosphine photoinitiators sold under the trade designations of IRGACURE® and DAROCUR® from Ciba and BASF. Specific examples of suitable photoinitiators include 1-hydroxy-cyclohexyl-phenyl-ketone (available as BASF IRGACURE® IC-184); 2,4,6-trimethylbenzoyldiphenylphosphine oxide (available as BASF LUCIRIN® TPO); 2,4,6-trimethylbenzoylethoxyphenylphosphine oxide (available as BASF LUCIRIN® TPO-L); bis(2,4,6-trimethylbenzoyl)-phenyl-phosphine oxide (available as Ciba IRGACURE® 819) and other acyl phosphines; 2-methyl-1-(4-methylthio)phenyl-2-(4-morpholinyl)-1-propanone (available as Ciba IRGACURE® 907) and 1-(4-(2-hydroxyethoxy)phenyl)-2-hydroxy-2-methylpropan-1-one (available as Ciba IRGACURE® 2959); 2-benzyl 2-dimethylamino 1-(4-morpholinophenyl)butanone-1 (available as Ciba IRGACURE® 369); 2-hydroxy-1-(4-(4-(2-hydroxy-2-methylpropionyl)-benzyl)-phenyl)-2-methylp- ropan-1-one (available as Ciba IRGACURE® 127); 2-dimethylamino-2-(4-methylbenzyl)-1-(4-morpholin-4-ylphenyl)-butanone (available as Ciba IRGACURE® 379); titanocenes; isopropylthioxanthone; 1-hydroxycyclohexylphenylketone; benzophenone; 2,4,6-trimethylbenzophenone; 4-methylbenzophenone; diphenyl-(2,4,6-trimethylbenzoyl) phosphine oxide (available as BASF IRGACURE® IC-TPO); 2,4,6-trimethylbenzoylphenylphosphinic acid ethyl ester; oligo(2-hydroxy-2-methyl-1-(4-(1-methylvinyl)phenyl)propanone); 2-hydroxy-2-methyl-1-phenyl-1-propanone; benzyldimethylketal; and mixtures thereof. This list is not exhaustive, and any known photoinitiator that initiates the free-radical reaction upon exposure to a desired wavelength of radiation such as UV light can be used without limitation.

The photoinitiator may absorb radiation of about 200 to about 420 nanometers wavelengths in order to initiate cure of the UV curable composition, although use of initiators that absorb at longer wavelengths, such as the titanocenes that may absorb up to 560 nanometers, can also be used without restriction.

The photoinitiator can be present in any suitable or desired amount. In embodiments, the total amount of initiator included in the UV curable composition may be for example, from about 0.5 to about 15 percent by weight, or from about 1 to about 10 percent by weight, or from about 1 to about 5 percent by weight, based on the total solids weight of the UV curable composition.

The UV curable composition herein may also contain a colorant. Any suitable or desired colorant can be used in embodiments herein, including colorants, pigments, dyes, and the like and mixtures and combinations thereof.

The colorant can be present in the UV curable composition in any desired or effective amount, such as from about 0.05 to about 15 percent, or from about 0.1 to about 10 percent, or from about 1 to about 5 percent by weight, based on the total solids weight of the UV curable composition.

In embodiments, the 3D UV curable composition structural material herein possesses a glass transition temperature (Tg) equal to or less than 130 °C when cured. In embodiments, the UV curable composition has glass transition temperature of equal to or less than 120 °C when cured. In embodiments, the UV curable composition has glass transition temperature of equal to or less than 100 °C or less than 80 °C, or less than 70 °C when cured.

In embodiments, the UV curable composition is a low-viscosity composition. The term "low-viscosity" is used in contrast to conventional high-viscosity inks such as screen printing inks, which tend to have a viscosity of at least 1,000 centipoise (cps). In specific embodiments, the UV curable composition disclosed herein has a viscosity from about 5 to about 20 cps, or from about 5 to about 15 cps, or from about 7 to about 10 cps measured at a temperature of 65 °C to 95 °C.

In embodiments, the 3D UV curable composition herein has a Storage Elastic Modulus at 25 °C of from about 1000 MPa to about 2500 MPa or from about 1300 to about 2000 MPa, or from about 600 to about 1200 MPa when cured.

In embodiments, the 3D UV curable composition herein has a Loss Modulus at 70 °C of from about 50 to about 3000 MPa or from about 80 to about 1000 MPa, or from about 100 to about 500 MPa when cured.

The UV curable compositions can be prepared by any suitable process, such as by simple mixing of the ingredients. One process entails mixing all of the UV curable composition ingredients together and filtering the mixture to obtain UV curable composition structural material. UV curable compositions can be prepared by mixing the ingredients, heating if desired, and filtering, followed by adding any desired additional additives to the mixture and mixing at room temperature with moderate shaking until a homogeneous mixture is obtained, in embodiments from about 5 to about 10 minutes. Alternatively, the optional UV curable composition additives can be mixed with the other UV curable ingredients during the UV curable composition preparation process, which takes place according to any desired procedure, such as by mixing all the ingredients, heating if desired, and filtering. In other embodiments, at least one difunctional or multifunctional (tri- or higher functional oligomer) are mixed together with stirring and optional heat, followed by mixing at least one monofunctional monomer, followed by optional filtration. Optionally, the monomers, difunctional and/or multifunctional oligomers can be added together in reverse sequence. In another embodiments, all the monomers and oligomers can, optionally, be added together prior to heat and filtration, or the monomers, difunctional and/or multifunctional oligomers can be added together in reverse sequence.

The process for applying a UV curable composition as disclosed herein to a substrate in an imagewise pattern. The UV curable compositions can be used in a process which entails incorporating the UV curable composition into an ink jet printing or copying apparatus and causing droplets of the UV curable composition to be ejected in an imagewise pattern onto a substrate. In a specific embodiment, the printing apparatus employs a thermal ink jet process wherein the UV curable composition in the nozzles is selectively heated in an imagewise pattern, thereby causing droplets of the UV curable composition to be ejected in imagewise pattern. In another embodiment, the printing apparatus employs an acoustic ink jet process wherein droplets of the UV curable composition are caused to be ejected in imagewise pattern by acoustic beams. In yet another embodiment, the printing apparatus employs a piezoelectric ink jet process, wherein droplets of the UV curable composition are caused to be ejected in imagewise pattern by oscillations of piezoelectric vibrating elements. Any suitable substrate can be employed.

In some embodiments, UV curable composition produces three dimensionally printed structure comprising a structural material of the UV curable composition. A support material can be used to support at least one layer of a structural material during the 3D printing process and is able to be removed following the object printing process. In some embodiments, a three dimensionally printed article described herein comprises a plurality of layers of the structural material, wherein the layers of the structural material are deposited according to data in a computer readable format. In some embodiments, at least one of the deposited layers of structural material is supported by a support material. In some embodiments, the support material is removable to complete production of the three dimensionally printed article or object.

In some embodiments, the layers of the structural material are deposited according to an image of the three dimensional article in a computer readable format. In some embodiments, the structural material is deposited according to preselected computer aided design (CAD) parameters.

In some embodiments, a preselected amount of structural material described herein is heated to the appropriate temperature and jetted through the print head or a plurality of print heads of a suitable inkjet printer to form a layer on a structural support platform. In some embodiments, each layer of structural material is deposited according to the preselected CAD parameters. A suitable print head to deposit the structural material, in some embodiments, is the Xerox Corporation piezoelectric Z850 print head. Additional suitable print heads for the deposition of structural and support materials described herein are commercially available from a variety of ink jet printing apparatus manufacturers. For example, print heads available from Xerox or Ricoh print heads may also be used in some embodiments.

Layered deposition of the structural material and support material can be repeated until the three dimensional article has been formed. In some embodiments, a method of printing a three dimensional article further comprises removing the support material from the structural material. The support material can be removed by any means known to one of ordinary skill in the art and not inconsistent with the objectives of the embodiments herein.

The conductive metal ink composition disclosed herein contain a combination of aromatic hydrocarbon solvent and aliphatic hydrocarbon solvent and a plurality of metal nanoparticles. The solvents are compatible with the metal nanoparticles so as to provide a stable ink composition.

The at least one aromatic hydrocarbon solvent can be any suitable or desired aromatic hydrocarbon solvent or a combination of aromatic hydrocarbon solvent or solvents is compatible with the metal nanoparticle. In embodiments, the at least one aromatic hydrocarbon is selected from the group consisting of phenylcyclohexane, toluene, mestylene, m-xylene, ethylbenzene, and combinations thereof.

The at least one aliphatic hydrocarbon solvent can be any suitable or desired aliphatic hydrocarbon solvent or combination of aliphatic hydrocarbon solvents provided that the aliphatic hydrocarbon solvents or solvents is compatible with the metal nanoparticle.

In embodiments the at least one aliphatic hydrocarbon solvent is selected from the group consisting of ethylcyclohexane, methylcyclohexane, terpineol, bicyclohexyl, decahydronaphthalene, cyclohexane, and combinations thereof.

The combination of the aromatic hydrocarbon solvent and aliphatic hydrocarbon solvent facilitates the dispersion of the metal nanoparticles and provides a uniform, stable nanoparticle conductive metal ink composition. In an embodiment, the conductive metal ink composition will remain stable for a period of time, such as a day, a week or a month or more, at room temperature. In an embodiment, the dispersion will remain stable for at least six months, such as a year or longer at a temperature of 5°C. Further, the solvent combination may help to reduce or prevent aggregation of the nanoparticles. By incorporating certain amounts of the first and second solvents in the metal nanoparticle inkjet ink formulation, the ink printing properties, such as latency, can be improved.

The aromatic hydrocarbon solvent and the aliphatic hydrocarbon solvent may be present at any suitable ratio. For example, a ratio by weight of the aromatic hydrocarbon solvent to the aliphatic hydrocarbon solvent can range from about 99:1 to about 1:99, or from about 80:20 to about 20:80, or from about 70:30 to about 30:70. The total amount of the aromatic hydrocarbon solvent and aliphatic hydrocarbon solvent may be present in the metal nanoparticle dispersion in an amount of at least 10 wt. %, based on the wt. % of the entire dispersion, such as, for example from about 10 wt. % to about 90 wt. %, from about 20 wt. % to about 80 wt. %, from about 30 wt. % to about 70 wt. % and from about 40 wt. % to about 60 wt. % of the conductive metal ink composition.

The term "nano" as used in "metal nanoparticles" refers to, for example, a particle size of 100 nm or less, such as, for example, from about 0.5 nm to about 100 nm, for example, from about 1 nm to about 50 nm, from about 1 nm to about 25 nm, or from about 1 nm to about 10 nm. The particle size refers to the average diameter of the metal particles, as determined by TEM (transmission electron microscopy). Generally, a plurality of particle sizes may exist in the metal nanoparticles obtained from the process described herein. In embodiments, the existence of different sized metal-containing nanoparticles is acceptable.

In embodiments, the metal nanoparticles are composed of (i) one or more metals or (ii) one or more metal composites. Any suitable metals can be employed. Examples of metals include Al, Ag, Au, Pt, Pd, Cu, Co, Cr, In, and Ni, particularly the transition metals, such as, Ag, Au, Pt, Pd, Cu, Cr, Ni, and mixtures thereof. Suitable metal composites may include Au--Ag, Ag--Cu, Ag--Ni, Au--Cu, Au--Ni, Au--Ag--Cu, and Au--Ag--Pd. The metal composites may also include non-metals, such as, for example, Si, C, and Ge. The various components of the metal composite may each be present in the composite in any amount, such as amounts ranging for example from about 0.01% to about 99.9% by weight, particularly from about 10% to about 90% by weight, with the amounts being adjusted to provide desired characteristics, such as to provide the desired conductivities for the resulting printed features.

In an embodiment, the metal nanoparticles comprise silver. For example, the metal of the nanoparticles can be a metal alloy composed of silver and one, two or more other metals, with silver comprising, for example, at least about 20% of the nanoparticles by weight, particularly greater than about 50% of the nanoparticles by weight. Unless otherwise noted, the weight percentages recited herein for the components of the metal nanoparticles do not include the weight of any stabilizer or oxide formation that may be part of the nanoparticle. The metal nanoparticles may be a mixture of two or more bimetallic metal nanoparticle species.

The conductive metal ink compositions of the present disclosure can include any suitable amount of metal nanoparticles. In an embodiment, the metal nanoparticles are in a concentration ranging from about 10 wt. % to about 90 wt. %, such as about 20 wt. % to about 80 wt. %, such as about 30 wt. % to about 70 wt. %, based on the total weight of the conductive metal ink composition.

The metal nanoparticles can optionally include one or more organic stabilizing groups attached thereto to form a stabilized nanoparticle complex. Stabilizing groups (which may be referred to herein as stabilizers, stabilizer groups or ligands) are generally well known in the art for enhancing or maintaining the dispersability of nanoparticles and/or to reduce aggregation of the nanoparticles in a dispersion. The term "attached" in the context of the stabilizing groups being attached to the nanoparticles means that the stabilizer is generally physically or chemically associated with the surface of the nanoparticles. In this way, the nanoparticles (e.g., silver nanoparticles or other metal nanoparticles described herein) have the stabilizer thereon outside of a liquid solution. That is, the nanoparticles with the stabilizer thereon may be isolated and recovered from a reaction mixture solution used in forming the nanoparticle and stabilizer complex. The stabilized nanoparticles may thus be subsequently readily and homogeneously dispersed in a solvent for forming a printable liquid.

As used herein, the phrase "physically or chemically associated" used to describe the attachment between the nanoparticles and the stabilizer may be a chemical bond and/or other physical attachment. The chemical bond may take the form of, for example, covalent bonding, hydrogen bonding, coordination complex bonding, or ionic bonding, or a mixture of different chemical bonds. The physical attachment may take the form of, for example, van der Waals' forces or dipole-dipole interaction, or a mixture of different physical attachments. The stabilizer can be attached to the nanoparticle via a linking group or directly to the nanoparticle itself.

The term "organic" in "organic stabilizing group" or "organic stabilizer" refers to, for example, the presence of carbon atom(s), but the organic stabilizer may include one or more non-metal heteroatoms such as nitrogen, oxygen, sulfur, silicon, halogen, and the like. The organic stabilizer may be an organoamine stabilizer. Examples of the organoamine are an alkylamine, such as for example butylamine, pentylamine, hexylamine, heptylamine, octylamine, nonylamine, decylamine, hexadecylamine, undecylamine, dodecylamine, tridecylamine, tetradecylamine, diaminopentane, diaminohexane, diaminoheptane, diaminooctane, diaminononane, diaminodecane, diaminooctane, dipropylamine, dibutylamine, dipentylamine, dihexylamine, diheptylamine, dioctylamine, dinonylamine, didecylamine, methylpropylamine, ethylpropylamine, propylbutylamine, ethylbutylamine, ethylpentylamine, propylpentylamine, butylpentylamine, tributylamine, trihexylamine, and the like, or mixtures thereof. These organoamines can be attached to the nanoparticle in any desired manner, such as via a carboxylate linking group or other carboxylic acid derived linking group, as in the carboxylic acid-organoamine complex stabilized silver nanoparticles mentioned herein.

Examples of other organic stabilizers include thiol and its derivatives, --OC(-S)SH (xanthic acid), polyethylene glycols, polyvinylpyridine, polyvinylpyrolidone, and other organic surfactants. The organic stabilizer may be selected from the group consisting of a thiol such as, for example, butanethiol, pentanethiol, hexanethiol, heptanethiol, octanethiol, decanethiol, and dodecanethiol; a dithiol such as, for example, 1,2-ethanedithiol, 1,3-propanedithiol, and 1,4-butanedithiol; or a mixture of a thiol and a dithiol. The organic stabilizer may be selected from the group consisting of a xanthic acid such as, for example, O-methylxanthate, O-ethylxanthate, O-propylxanthic acid, O-butylxanthic acid, O-pentylxanthic acid, O-hexylxanthic acid, O-heptylxanthic acid, O-octylxanthic acid, O-nonylxanthic acid, O-decylxanthic acid, O-undecylxanthic acid, O-dodecylxanthic acid. Organic stabilizers containing a pyridine derivative (for example, dodecyl pyridine) and/or organophosphine that can stabilize metal nanoparticles may also be used as a potential stabilizer.

In embodiments, the conductive ink composition has a viscosity of from about 1 to about 30, or from about 2 to about 20, or from about 3 to about 15 centipoise at a temperature range of from about 20 to about 30° C. and shear rate of from about 40 to about 400 s⁻¹.

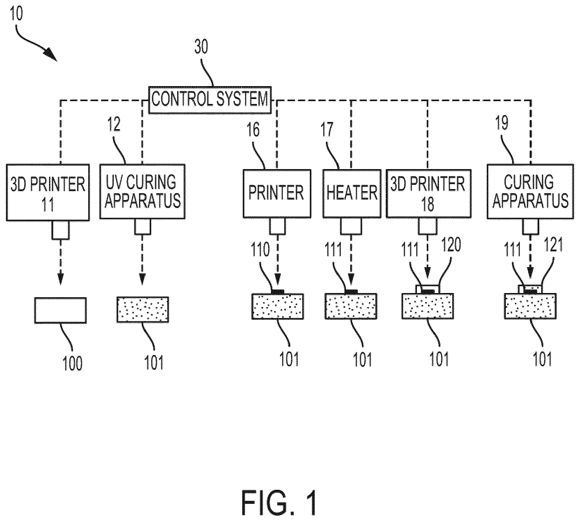

FIG. 1 shows a schematic depiction of a system 10 for printing according to embodiments disclosed herein. As shown, the system 10 can include a 3D printer 11 programmed to deposit a UV curable composition 100. The UV curable composition 100 can be any material that can be cured through UV radiation as disclosed above. A 3D printer 11 can be an ink jet printer with multiple jetting systems or an aerosol printer with multiple jetting systems or a combination thereof. UV curing apparatus 12 emits UV radiation to cure the UV curable composition into a solid 3D structure 101.

A conductive metal ink composition 110 is then applied to the solid 3D structure 101 by printer 16. Printer 16 can be an aerosol printer or and ink jet printer. The conductive metal ink composition 110 is heated by heater 17, or in embodiments a photonic curing apparatus at a temperature of less than the glass transition temperature of the UV curable composition for a time sufficient to anneal the metal conductive ink composition 110 into a conductive trace 111. The heater 17 can include an oven or a heated platen, such as a hotplate or a hot air gun.

The printer system 10 includes a 3D printer 18 for depositing curable composition 120 over the annealed conductive trace 111. Printer 18 can be an aerosol printer or and ink jet printer. The 3D printer 11 and 3D printer 18 can be a single printer. Printer 18 can deposit a thermally or UV curable composition over the conductive trace 111.

The curable composition 120 is cured through curing apparatus 19, which can provide heat or UV radiation to form a cured composition 121. Conductive trace 111 is embedded within cured UV composition 101 and cured composition 121. The UV curing apparatus 12 and curing apparatus 19 can be a single system. The final product is a 3D printed article having conductive traces embedded therein.

In various embodiments, FIG. 1 the printers 11, 16 and 18 can be a single printer having multiple printheads connected to reservoirs for the compositions that are coated. Each printhead can be configured to jet a specific composition. The multiple printheads can include aerosol printhead or ink jet printheads or both. For purposes of the discussion below, distinct printers are identified which also refers to a single printer having multiple distinct printheads.

In various embodiments, FIG. 1 shows a printing system 10 for producing a 3D article having an embedded conductive trace. The printing system 10 can include a control system 30 coupled to the 3D printer 11, UV curing apparatus 12, metal conductive ink printer 16, heating system 17, a second 3D printer 18 and a second curing apparatus 19. In embodiments the 3D printer 11 and 3D printer 18 can be one printer and the flow of product adjusted accordingly. In embodiments the 3D printer 11, printer 16 and 3D printer 18 can be one printer with multiple printheads. Likewise, in embodiments the UV curing apparatus 12 and curing apparatus 19 can be one apparatus. The control system 30 can be configured to provide instructions to, and/or otherwise control operation of 3D printer 11, UV curing apparatus 12, metal conductive ink printer 16, heating system 17, second 3D printer 18 and curing apparatus 19. The control system 30 may be mechanically or electrically connected to 3D printer 11, UV curing apparatus 12, metal conductive ink printer 16, heating system 17, second 3D printer 18 and curing apparatus 19. Control system 30 may be a computerized, mechanical, or electro-mechanical device capable of controlling the 3D printer 11, UV curing apparatus 12, metal conductive ink printer 16, heating system 17, second 3D printer 18 and curing apparatus 19. In one embodiment, control system 30 may be a computerized device capable of providing operating instructions to the 3D printer 11, UV curing apparatus 12, metal conductive ink printer 16, heating system 17, second 3D printer 18 and curing apparatus 19. In another embodiment, control system 30 may include a mechanical device, capable of use by an operator. In this case, the operator may physically manipulate control system 30 (e.g., by pulling a lever), which may actuate the 3D printer 11, UV curing apparatus 12, metal conductive ink printer 16, heating system 17, second 3D printer 18 and curing apparatus 19. In another embodiment, control system 30 may be an electro-mechanical device.

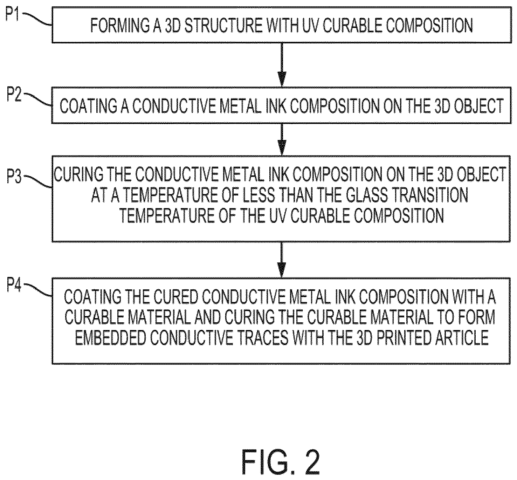

FIG. 2 shows a flow chart illustrating a method performed according to various embodiments.
Process P1: A 3D article is produced through a 3D printer. The 3D article is produced from a UV curable material such as a polyacrylate or a polymethacrylate having a glass transition temperature. After UV curing, the 3D article is ready for process P2.
Process P2: A conductive metal ink composition is coated on a surface of the 3D article from P1.
Process P3: The conductive ink composition is heated to anneal the composition to form a conductive trace on the surface of the 3D structure. The heating is done at temperature of less than the glass transition temperature of the UV curable composition. In embodiments the annealing temperature of the conductive metal ink composition can be less than 120°C, or the annealing temperature can less than 110°C, or in embodiments the annealing temperature can be 100 °C or less, or in embodiments the annealing temperature can be 90 °C or in embodiments the annealing temperature can be 80 °C, or in embodiments the annealing temperature can be 70 °C. In embodiments, the annealing of the conductive ink composition can be done through radiation, e.g. photonically. In embodiments the temperature of annealing the conductive ink is at room temperature, or about 25 °C.
Process P4: A curable material is applied over the conductive trace and cured with UV radiation or with heat. If the curable material is thermally cured, the curing temperature is less than the glass transition temperature of the UV curable composition. In embodiments, a thin overcoat can be applied over the conductive trace. The thin overcoat can be thermally cured at a temperature of less than the glass transition temperature of the UV curable composition. Examples of such overcoat materials are described in US 9,828,520 and US8821962 which are herein incorporated by reference in their entirety.

### Example 1

UV curable compositions were prepared by adding at least one oligomer, and at least one difunctional or multifunctional monomer (tri-functional or higher monomers) to a glass container with a magnetic stirring rod. The compositions were allowed to stir on a Vario-Mag® heated stirring block at about 85 °C for about 20 minutes. After the compositions were mixed to form a homogeneous liquid mixture, optional additional monofunctional monomers and at least one photoinitiator were added, and mixed for another approximately 30 minutes to furnish the final mixed UV curable compositions. The UV curable compositions were filtered through 1µm filter cloth (available from Parker). The UV curable compositions are shown in Table 1.

**Table 1: UV Curable Compositions**

| | Weight (%) | |
|---|---|---|
| | UV Curable Composition 1 | UV Curable Composition 2 |
| SR506A (isobornyl acrylate) | 39.40 | 26.0 |
| SR272 (TriEGDA-Triehylene glycol diacrylate) | 16.10 | 10.5 |
| SR268 (TetraEGDA-Tetraethylene glycol diacrylate) | 7.36 | 3.5 |
| SR368 (tris-2-hydroethyl acrylate isocyanurate) | 12.00 | 7.0 |
| BR-741 (Bomar-Aliphatic polyester urethane acrylate) | 21.80 | |
| BR-952 (Urethane acrylate oligomer) | | 50.0 |
| IC TPO (Diphenyl(2,4,6-trimethylbenzoyl)phosphine oxide) | 2.30 | 0.50 |
| Irgacure 184 | 1.00 | 2.50 |
| Total | 100 | 100 |

| Formulation Properties | | |
|---|---|---|
| Viscosity at 80 °C (cps) | 5.42 | ND |
| Storage Modulus of cured ink at 25 °C (MPa) | ND | 1956 |

Viscosity was measured using an Ares G2 rheometer equipped with a 25 mm Parallel plate and Peltier heating system. Samples of the UV Curable compositions were loaded on the rheometer at 102 °C, allowed to equilibrate, then swept over temperature to 25 °C at a rate of 1.5 °C/min at 10 rad/s. Storage modulus of cured samples was tested using a DMA (Dynamic Mechanical Analysis) Q800 apparatus, commercially available from TA Instruments.

A UV curable 3D structure was fabricated. UV Curable Composition 1 was loaded into a reservoir (set at a temperature of 80°C) of digital printing fixture equipped with the Xerox Corporation piezoelectric Z850 print head. Layer heights normally fell in the 20-22 nm range. Final printed part dimensions averaged approximately 35 mm by 70 mm by 1-2 mm. Each layer was subjected to LED curing for 500 ms at 100 percent power, with a gap of lamp to substrate of 5 mm. The UV light was supplied by Phoseon FireJet FJ200 150-20 (emitting window dimensions [mm]) 395 nm (wavelength) and 8W/cm² (power). The 3D structures produced were used as described below.

### Example 2

### Preparation of Conductive Inks

Conductive Inks were prepared as outlined in US20170253757A1 and US20170298246A1 which are herein incorporated by reference in their entirety. Table 2 below shows the ink formulations and ink properties.

**Table 2: Conductive Ink Formulations**

| Ink Component | Mass (g) | |
|---|---|---|
| | Conductive Metal Ink 1 | Conductive Metal Ink 2 |
| Silver nanoparticle | 132.34 | 115.00 |
| Ethylcyclohexane | 15.90 | |
| Phenylcyclohexane | 31.80 | 46.00 |
| Bicyclohexane | | 69.00 |
| Total | 180.04 | 230 |

| Ink Properties | | |
|---|---|---|
| Viscosity (cps) | 11.89 | 5.38 |
| Silver Content (wt%) | 64.85 | 43.32 |

Conductive Metal Ink 2 was jetted onto the 3D structures described above, using a Fuji Dimatix DMP2800 printer equipped with a 10 pL cartridge. Conductive Metal Ink 2 was annealed at 80 °C for 1 hour in a conventional oven to give conductive lines. The annealing temperature of Conductive Metal Ink 2 was below the glass transition temperature of the UV curable composition 1.

Table 3 shows the average resistance of printed lines on the 3D structure made from UV curable composition 1. The lines printed on the 3D structure had low sheet resistance (comparable to lines printed on glass). This indicates that the UV curable material used to build the 3D structure and the conductive metal ink composition are compatible with the 3D structure and the 3D structure was not affected by the 80 °C curing temperature.

**Table 3; Resistance of Conductive Ink lines printed on 3D structure**

| Substrate | Annealing Conditions | Average resistance (ohms) |
|---|---|---|
| Glass (control) | 80 °C | 9.7 |
| 3D structure from UV Curable Composition 1 | 80 °C | 11.2 |

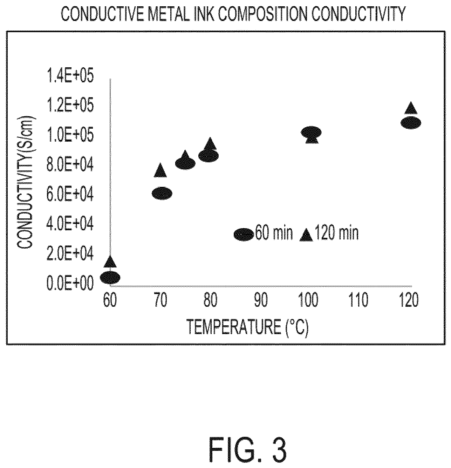

FIG. 3 shows the conductivity profile as a function of annealing temperature of the conductive metal ink of Conductive Ink 2. As the temperature increases, the conductivity increases to reach a maximum of about 1.2 x 10⁵ S/cm (bulk silver is 6.3 x 10⁵ S/cm). Conductivities as high as 6 x 10⁴ S/cm can be reached at temperatures significantly lower 90 °C when annealed for 1 or 2 hours. These conductivities are sufficient to build functional objects. Temperatures below 90 °C are compatible with UV cured 3D printed articles.

### Example 3

Overcoat materials were prepared as outlined in US 9,828,520 and US8821962. Table 3 below show the overcoat materials formulations and their properties

**Table 3: Overcoat Formulations**

| **Component** | **Overcoat Example 1** | **Overcoat Example 2** |
|---|---|---|
| | **wt%** | **wt%** |
| Poly(4-vinylphenol), 25kDa | 5.95% | 5.00% |
| Poly(melamine co-formaldehyde), methylated 84wt% solution in butanol | 5.84% | 5.60% |
| 1-butanol | 78.64% | |
| Silclean 3700 | 0.12% | |
| Nacure 5225 | 0.36% | |
| Methyltrimethoxysilane | 1.90% | |
| 0.1 wt% aq HCl | 0.51% | |
| THF | 2.38% | |
| 4-methyl-2-pentanone | 4.30% | |
| Propylene glycol monomethyl ether acetate | | 62.99% |
| 4-Methoxyphenol | | 0.02% |
| Poly(propylene glycol) diglycidyl ether (Mn 380) | | 26.39% |
| Total | 100.00% | 100.00% |

| **Material Properties** | | |
|---|---|---|
| Viscosity (cps) | 7.8 | 8.1 |
| Surface Tension (mN/m) | 24.4 | 29.6 |

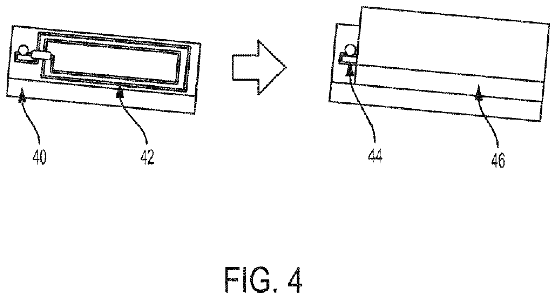

A fully printed antenna was fabricated on the 3D structure of Example 1 as shown in FIG. 4. To demonstrate the compatibility of the materials disclosed above and the ability to use them to print 3D printed articles. UV curable composition 1, was used to fabricate an antenna. FIG. 4 shows UV curable composition 1 forming a base 40 using the same process described in Example 1 to form the 3D structure. Conductive Metal Ink 1 was jetted onto the 3D structure of Example 1 to form conductive trace 42. The ink was jetted using an Optomec Aerosol Jet System in Pneumatic Aerosol mode (PA). A 300 µm nozzle was used with a 3 mm offset distance between the nozzle and the substrate. The printing rate was maintained at 10 mm/s. The following gas flow parameters were used to print Conductive Metal Ink 1: Sheath Gas = 50 cm³/min, Atomization Gas = 650 cm³/min, Exhaust gas = 630 cm³/min. The printed conductive lines were annealed in a conventional oven at 130 °C for 2 hours. Overcoat Example 1 was coated on top of the conductive traces 42. Overcoat Example 1 was dried at 80 °C for 10 minutes in air and cured at 120 °C for 1 hour in air to form thin layer over the conductive traces 42. These conductive traces 42 completed the antenna device. UV curable composition 1 was then jetted over the cured overcoat composition 1 to form topcoat 46 thereby forming a conductive trace 42 and embedded between topcoat 46 and base 40. Structure 46 was fabricated in the same way as structure 40. LED 44 was connected to the conductive trace 42. When the 3D printed antenna with connected LED came in contact with a wireless emitter, the LED lighted indicating that the antenna was working. Example 3 indicated that the process disclosed herein can be used to fabricate fully printed electronic circuits.

## Claims

1. A method for forming a three dimensional (3D) printed article, the method comprising:
depositing a UV curable composition;
applying UV radiation to cure the UV curable composition to form a 3D structure;
depositing a conductive metal ink composition on a surface of the 3D structure;
annealing the conductive metal ink composition at a temperature of less than a glass transition temperature of the UV curable composition to form a conductive trace on the 3D structure;
depositing a second UV curable composition over the conductive trace; and
curing second UV curable composition to form the 3D printed article having the conductive trace embedded therein.

2. The method of claim 1 where the UV curable composition comprises at least one monofunctional acrylate; an optional oligomer selected from the group consisting of a difunctional acrylate oligomer, a multifunctional acrylate oligomer and mixtures thereof; and a photoinitiator.

3. The method of claim 1 where the second curable composition comprises at least one monofunctional acrylate oligomer; an oligomer selected from the group consisting of a difunctional acrylate oligomer, a multifunctional acrylate oligomer and mixtures thereof; and a photoinitiator.

4. The method according to claim 1, wherein annealing the conductive metal ink composition is at a temperature of less than 120°C.

5. The method according to claim 1, wherein the conductive metal ink composition comprises:
at least one aromatic hydrocarbon solvent; at least one aliphatic hydrocarbon solvent; and
a plurality of metal nanoparticles.

6. The method according to claim 5, wherein the aromatic hydrocarbon solvent is selected from the group consisting of: phenylcyclohexane, toluene, mestylene, m-xylene, ethylbenzene, and combinations thereof.

7. The method according to claim 5, wherein the aliphatic hydrocarbon solvent is selected from the group consisting of ethylcyclohexane, methylcyclohexane, terpineol, bicyclohexane, decahydronaphthalene, cyclohexane and combinations thereof.

8. The method according to claim 5, wherein the plurality of metal nanoparticles are selected from the group consisting of Al, Ag, Au, Pt, Pd, Cu, Co, Cr, In and Ni.

9. The method according to claim 5, wherein the conductive ink composition includes an organic stabilizing group attached to the plurality of metal nanoparticles.

10. The method according to claim 1, further comprising depositing a thermally curing overcoat over the annealed conductive trace prior to depositing the second UV curable composition.

11. A printing system comprising:
a first three dimensional (3D) printer for depositing a UV curable composition;
a first UV curing apparatus for curing the UV curable composition to form a 3D structure;
a printer for depositing a conductive metal ink composition on a surface of the 3D structure;
a heater for drying and annealing the conductive metal ink composition at a temperature less than a glass transition temperature of the UV curable composition to form a conductive trace on the cured UV curable composition of the 3D structure;
a second 3D printer for depositing a second UV curable composition over the conductive trace; and
a second UV curing apparatus for curing the second UV curable composition deposited over the conductive trace to form a 3D printed article having a conductive trace embedded therein.

12. The system according to claim 11, wherein the first 3D printer, the printer for deposition of the conductive ink and the second 3D printer comprise a single printer having multiple printheads.

13. The system according to claim 11, wherein the second curing apparatus is a heater.

14. The system according to claim 11, wherein the second curing apparatus is a UV curing apparatus.

15. The system according to claim 14, wherein the first UV curing apparatus and the second curing apparatus comprise one apparatus.

16. A printing method comprising:
depositing a conductive metal ink composition on a surface of a three dimensional (3D) structure having a glass transition temperature; and
annealing the conductive metal ink composition at a temperature of less than the glass transition temperature to form a conductive surface on the 3D structure;
depositing a second UV curable composition over the conductive surface; and
curing the second UV curable composition to form 3D printed article having the conductive surface embedded therein.

17. The method according to claim 16, wherein annealing the conductive metal ink composition is at a temperature of less than 120°C.

18. The method according to claim 16, wherein curing the second curable composition is through thermal curing.

19. The method according to claim 16, wherein curing the second curable composition is through UV radiation curing.

20. The method of claim 16 where the 3D structure comprises at least one monofunctional acrylate; an optional oligomer selected from the group consisting of a difunctional acrylate oligomer, a multifunctional acrylate oligomer and mixtures thereof; and a photoinitiator.
